# EUROPEAN PATENT SPECIFICATION

(11) **EP 2 059 954 B1**
(45) Date of publication and mention of the grant of the patent: **19.10.2016**
(21) Application number: 07806441.7
(22) Date of filing: 24.08.2007
(51) Int. Cl.: H01L 33/50, H01L 25/075

(54) **SEMICONDUCTOR ELECTROLUMINESCENT AND PHOSPHOR-CONVERTED LIGHT SOURCE, METHOD FOR MANUFACTURING THE SAME**
HALBLEITER-ELEKTROLUMINESZENZ-, PHOSPHOR-GEWANDELTE-LICHTQUELLE UND HERSTELLUNGSVERFAHREN DAFÜR
SOURCE LUMINEUSE À SEMI-CONDUCTEURS ÉLECTROLUMINESCENTS ET À LUMINOPHORES, PROCÉDÉ DE FABRICATION CORRESPONDANT

(30) Priority: 29.08.2006 JP 2006232616
(43) Date of publication of application: 20.05.2009
(73) Proprietor: Panasonic Intellectual Property Management Co., Ltd., Osaka 540-6207 (JP)
(72) Inventor: UEMOTO, Takaari, Chuo-ku, Osaka-shi, Osaka 540-6207 (JP); NISHIMOTO, Keiji, Chuo-ku, Osaka-shi, Osaka 540-6207 (JP); UENO, Yasuharu, Chuo-ku, Osaka-shi, Osaka 540-6207 (JP); SHIDA, Satoshi, Chuo-ku, Osaka-shi, Osaka 540-6207 (JP)
(74) Representative: Eisenführ Speiser
(86) International application number: PCT/JP2007/066964
(87) International publication number: WO 2008/026717

(56) References cited:
- EP-A- 1 693 904
- WO-A-2005/124878
- WO-A-2006/030678
- WO-A-2006/041178
- US-A1- 2005 077 531
- DUGBARTEY N ET AL: "Contact angle and temperature dependence of contact angle of silicone encapsulant material" PROCEEDINGS OF THE SPIE - THE INTERNATIONAL SOCIETY FOR OPTICAL ENGINEERING SPIE-INT. SOC. OPT. ENG USA, vol. 3906, 1999, pages 293-297, XP008086254 ISSN: 0277-786X

## Description

### Technical Field

The present invention relates to a semiconductor electroluminescent light source including light-emitting elements covered with a phosphor layer, and a method for manufacturing the same.

### Background Art

Light-emitting elements such as light-emitting diodes (hereinafter referred to as "LED"), semiconductor lasers, etc. are used in various kinds of light-emitting devices. Among these, luminescent light sources in which LED bare chips are used are not only small in size and highly efficient as compared with conventional light sources that utilize electric discharge or radiation, but also have an increased luminous flux density recently. Therefore, such luminescent light sources may displace the conventional light sources.

Examples of a luminescent light source using a LED bare chip include a luminescent light source that includes a LED bare chip, a substrate connected to the LED bare chip, and a phosphor layer that contains a phosphor and covers the LED bare chip. Particular attention has been given to, among luminescent light sources of such a type, a luminescent light source that produces white output light by using a LED bare chip emitting blue light and a phosphor that is contained in a phosphor layer and emits yellow light.

Meanwhile, an electrical connection between a LED bare chip and a substrate is established by, for example, a method in which the LED bare chip bonded to the substrate via a non-conductive paste is connected to the substrate using a plurality of gold wires, a method in which the LED bare chip bonded to the substrate via a conductive paste or Au-Sn eutectic bonding is connected to the substrate using a gold wire, or a flip-chip connection method in which the LED bare chip is connected to the substrate via a bump. When the above-described luminescent light source using a LED bare chip is used as an illumination light source, the flip-chip connection method using no wire is more suitable since in the methods of establishing an electrical connection using a wire, it is likely that the shadow of the wire is projected on a surface to be irradiated.

In the flip-chip connection method, generally, a LED bare chip is connected electrically to a conductor pattern on a substrate via a bump formed of gold or solder. In this case, the bump is formed directly on the LED bare chip or the conductor pattern (e.g., lands) formed on the substrate. Further, there also is a method in which, after a LED bare chip is connected to a substrate, an underfill further is filled into a gap between the LED bare chip and the substrate (see, for example, JP 2003-101075 A). An underfill generally is a liquid material formed of, for example, a resin such as an epoxy resin or the like. Through the use of this, the bonding between a LED bare chip and a substrate can be reinforced.

However, an underfill may run up to a side face of a LED bare chip or spread to an area other than an area between the LED bare chip and a substrate. Such a case causes a phosphor layer to have an unstable shape, that is, the phosphor layer covering the LED bare chip to have a non-uniform thickness, leading to uneven chromaticity of output light, which is problematic.

Moreover, in the case where an underfill and a phosphor layer are formed of different materials from each other, particularly, when the phosphor layer contains a silicone resin having less adhesiveness, peeling is likely to occur at an interface between the underfill and the phosphor layer, which also is problematic.

To solve the above-described problems, a method for manufacturing a luminescent light source without using an underfill has been proposed, which is enabled by disposing a light-transmitting base material of a phosphor layer forming material between light-emitting elements and a substrate (see WO 2006/041178 A2).

However, according to the manufacturing method described in WO 2006/041178 A2 , the content of phosphor dispersed in the light-transmitting base material disposed between light-emitting elements and a substrate decreases. Therefore, the content of phosphor dispersed in the light-transmitting base material possibly becomes significantly different from the content of phosphor in the phosphor layer covering the light-emitting elements. As a result, a significant difference is generated between a heat dissipation property of a layer over the light-emitting elements and a heat dissipation property of a layer under the light-emitting elements, and such a significant difference of the heat dissipation properties causes a thermal stress, which causes the phosphor layer to peel off from the substrate.

### Disclosure of Invention

The present invention is to solve the problem of the conventional art, and is to provide a semiconductor electroluminescent light source in which a difference between heat dissipation properties of a phosphor layer over and under light-emitting elements can be decreased, and a method for manufacturing such a semiconductor electroluminescent light source.

A semiconductor electroluminescent light source of the present invention is defined by the appended claim 1.

A method of the present invention for manufacturing a semiconductor electroluminescent light source is defined by the appended claim 3.

According to the semiconductor electroluminescent light source and the method for manufacturing a semiconductor electroluminescent light source of the present invention, it is possible to decrease a difference between thermal dissipation properties of layers over and under light-emitting elements. Therefore, a defect caused by thermal stress, such as the peeling-off of the phosphor layer from the substrate, etc. can be prevented.

### Brief Description of Drawings

FIG. 1A is a perspective view schematically illustrating a semiconductor electroluminescent light source according to an embodiment of the present invention, FIG. 1B is a plan view of a substrate used in the electroluminescent light source shown in FIG.
   1A, and FIG. 1C is a cross-sectional view taken along a line I-I shown in FIG. 1A.
FIGS. 2A to 2E are cross-sectional views showing steps of a preferred method for manufacturing the semiconductor electroluminescent light source according to an embodiment of the present invention.
FIG. 3 is a graph showing, regarding each of the Example of the present invention and Comparative Examples when lit up, a difference between temperatures of a center part of an upper surface of a phosphor layer and a center part of a lower surface of a substrate.

### Description of the Invention

A semiconductor electroluminescent light source of the present invention includes a substrate, a terminal and lands formed on the substrate, and light-emitting elements mounted on the lands via bumps.

The material for forming the substrate is not limited particularly, and for example, a ceramic material made of Al₂O₃, AlN, etc., a composite material containing an inorganic filler and a thermosetting resin, or the like can be used. Alternatively, a laminate material obtained by forming an electric insulation layer (e.g., the above-described composite material) on a metal material made of aluminum or the like may be used, in order to increase the head dissipation property of the substrate. The substrate has a thickness of, for example, about 0.5 mm to 3 mm.

For forming the terminal, the lands, and the bumps, commonly used materials can be used. For example, the terminal and the lands can be formed by using copper, or by using copper and plating it with nickel and gold, or the like, and the bumps can be formed by using gold, solder, or the like.

As light-emitting elements, for example, a blue LED that emits a blue light having a wavelength of 420 nm to 500 nm, a blue-violet LED that emits a blue-violet light having a wavelength of 380 nm to 420 nm, or the like can be used. As the blue LED or the blue-violet LED, for example, a LED formed with an InGaAlN-based material can be used. It should be noted that the number of the light-emitting elements disposed on the substrate is not limited particularly, and the number may be set appropriately according to a required light amount.

In addition to the above-described constituent elements, the semiconductor electroluminescent light source of the present invention further includes a phosphor layer that covers the light-emitting elements and is filled in interstices between a principal surface of the substrate and the light-emitting elements. The phosphor layer contains a phosphor and a light-transmitting base material, and a content by volume of the phosphor in the part of the phosphor layer filled in the interstices (a region where this part is formed is hereinafter referred to as "first region") and a content by volume of the phosphor in the part of the phosphor layer covering the light-emitting elements (a region where this part is formed is hereinafter referred to as "second region") are substantially equal to each other. This causes a thermal conductivity in the second region positioned on a light output side to the light-emitting elements and a thermal conductivity in the first region positioned on the opposite side to be substantially equal to each other, whereby a difference between the heat dissipation properties of layers over and under the light-emitting elements can be decreased. Accordingly, a defect caused by thermal stress, such as the peeling-off of the phosphor layer from the substrate, etc. can be prevented. It should be noted that the expression "substantially equal" implies that a phosphor is contained in the first and second regions so that respective thermal conductivities in the first and second regions become substantially equal to each other. In particular, the content by volume of the phosphor in the first region is not less than 80 % of the content by volume of the phosphor in the second region, and preferably the former is not less than 90 % and not more than 100 % of the latter.

As the phosphor contained in the phosphor layer, for example, red phosphor that emits red light, yellow phosphor that emits yellow light, green phosphor that emits green light, or the like can be used. As the red phosphor, for example, nitride silicate-based Sr₂Si₅N₈:Eu²⁺, nitride aluminosilicate-based CaAlSiN₃:Eu²⁺, oxonitride aluminosilicate-based Sr₂Si₄AlON₇:Eu²⁺, LOS-based La₂O₂S:Eu³⁺, or the like can be used. As the yellow phosphor, for example, (Sr, Ba)₂SiO₄:Eu⁺², (Y, Gd)₃Al₅O0₁₂:Ce³⁺, or the like can be used. As the green phosphor, for example, BaMgAl₁₀O₁₇:Eu²⁺, BaMgAl₁₀O₁₇:Mn²⁺, SrAl₂O₄:Eu²⁺, silicate-based (Ba, Sr)₂SiO₄:Eu²⁺, or the like can be used. It should be noted that in the case where a LED that emits a blue-violet light having a wavelength of not more than 420 nm, or a LED that emits an ultraviolet light having a wavelength of not more than 380 nm is used as light-emitting element, as phosphor, for example, the above described red phosphor or green phosphor, may be used in combination with a blue phosphor that emits a blue light. As this blue phosphor, for example, aluminate phosphor such as BaMgAl₁₀O₁₇:Eu²⁺, silicate phosphor such as Ba₃MgSi₂O₈:Eu²⁺, or the like can be used.

The light-transmitting base material that forms the phosphor layer is not limited particularly as long as a phosphor can be dispersed therein and outputted light can be transmitted therethrough, but a light-transmitting resin such as a silicone resin or an epoxy resin is preferred. Among these, the silicone resin is more preferred because of its good lightfast property and high flowability before being cured; these properties make the filling into the first region easier in a manufacturing process that will be described later.

In the semiconductor electroluminescent light source of the present invention, each land has an area larger than an area of each light-emitting element mounted on the lands. Preferably, each land has an area not less than 1.3 times the area of each light-emitting element. This is because such a configuration makes the filling into the first region easier in the manufacturing process that will be described later.

The following describes a method for manufacturing a semiconductor electroluminescent light source of the present invention. It should be noted that since the method for manufacturing a semiconductor electroluminescent light source described below is a preferred method for manufacturing the above-described semiconductor electroluminescent light source of the present invention, duplicate descriptions of the already-described contents are omitted in some cases.

The method of the present invention for manufacturing a semiconductor electroluminescent light source includes the steps of: disposing a peelable resin coating layer on a substrate on which a terminal and lands are formed, in a manner such that the peelable resin coating layer covers the terminal; mounting light-emitting elements on the lands via bumps; disposing a phosphor layer forming material containing a phosphor and a light-transmitting base material under an ambient atmosphere pressure of less than 20 Pa so that the material covers the light-emitting elements and is filled in interstices between a principal surface of the substrate and the light-emitting elements (i.e., the first region); and peeling off the peelable resin coating layer. Since in this method the phosphor layer forming material is disposed under a reduced pressure of less than 20 Pa, the phosphor layer forming material containing a phosphor can be filled in the first region easily. Therefore, a semiconductor electroluminescent light source of the present invention in which the content by volume of the phosphor in the first region and the content by volume of the phosphor in the second region are substantially equal to each other can be manufactured easily. Besides, since the terminal is covered with the peelable resin coating layer in the step of disposing the phosphor layer forming material, it is possible to prevent the phosphor layer forming material from adhering to the terminal.

The peelable resin coating layer may be formed with any material as long as the material can adhere closely to the terminal so as to prevent the phosphor layer forming material from adhering to the terminal and is easy to peel off from the terminal. For example, the material may be made of an acrylic resin, vinyl chloride, or the like.

The step of disposing the phosphor layer forming material is performed under an ambient atmosphere pressure of less than 20 Pa, and preferably in an ambient atmosphere of not less than 1 Pa and not more than 10 Pa. This is because this condition makes the filling into the first region easier.

In the method of the present invention for manufacturing a semiconductor electroluminescent light source, preferably a contact angle of the phosphor layer forming material with respect to surfaces of the lands (contact angle θ₁) is smaller than a contact angle of the phosphor layer forming material with respect to the principal surface of the substrate (contact angle θ₂). Particularly preferably, θ₁/θ₂ is not more than 2/3. This is because this condition makes the filling into the first region easier. For example, in the case where alumina is used as a material for the substrate, gold is used as a material for forming the surfaces of the lands, and a silicone resin is used as a light-transmitting base material of the phosphor layer forming material, the contact angle of the phosphor layer forming material with respect to the land surfaces is about 60°, while the contact angle of the phosphor layer forming material with respect to the principal surface of the substrate is about 90°. Therefore, the filling into the first region can be performed easily.

Hereinafter, the present invention will be described by way of illustrative embodiments with reference to the drawings. It should be noted that in the drawings referred to, constituent elements having substantially the same functions are designated with the same reference numerals and duplicate descriptions of such elements are omitted in some cases.

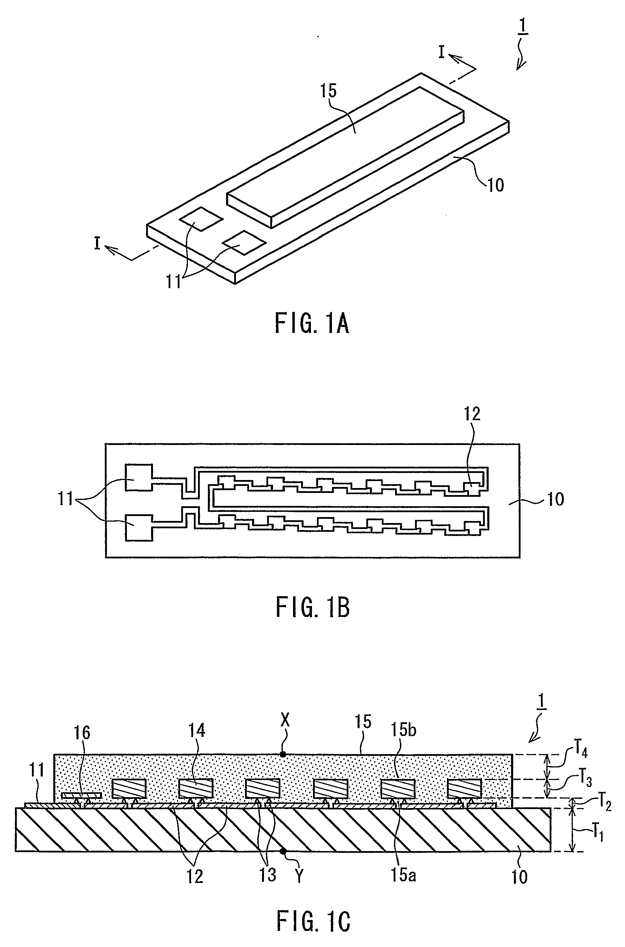

FIG. 1A is a perspective view schematically illustrating a semiconductor electroluminescent light source according to an embodiment of the present invention. FIG. 1B is a plan view of a substrate used in the electroluminescent light source shown in FIG. 1A, and FIG. 1C is a cross-sectional view taken along a line I-I shown in FIG. 1A.

As shown in FIGS. 1A and 1C, the semiconductor electroluminescent light source 1 includes a substrate 10, a terminal 11 and lands 12 formed on the substrate 10, light-emitting elements 14 mounted on the lands 12 via bumps 13, and a phosphor layer 15 that covers the light-emitting elements 14 and is filled in the first region 15a, i.e., the interstices between a principal surface of the substrate 10 and the light-emitting elements 14. Further, on the substrate 10, an antistatic member 16 (e.g., a Zener diode, varistor, etc.) is mounted so as to extend over the terminal 11 and the land 12.

As shown in FIG. 1B, the terminal 11 and the lands 12 are arranged so that the light-emitting elements 14, which are 6×2=12 in number, are connected in series.

The phosphor layer 15 contains a phosphor and a light-transmitting base material. A content by volume of the phosphor in the phosphor layer 15 in the first region 15a and a content by volume of the phosphor the phosphor layer 15 in the second region 15b, which is the region covering the light-emitting elements 14 (see FIG. 1C), are substantially equal to each other. This causes a thermal conductivity in the second region 15b positioned on a light output side to the light-emitting elements 14 and a thermal conductivity in the first region 15a positioned on the opposite side to be substantially equal to each other, whereby a difference between the heat dissipation properties of layers above and under the light-emitting elements 14 can be decreased. Accordingly, a defect caused by thermal stress, such as the peeling-off of the phosphor layer 15 from the substrate 10, etc. can be prevented.

In the semiconductor electroluminescent, phosphor-converted light source 1, each land 12 has an area larger than an area of each light-emitting element 14 mounted on the land 12. This makes it easier to fill the phosphor layer forming material in the first region 15a in the manufacturing process of the semiconductor electroluminescent light source 1 that will be described later.

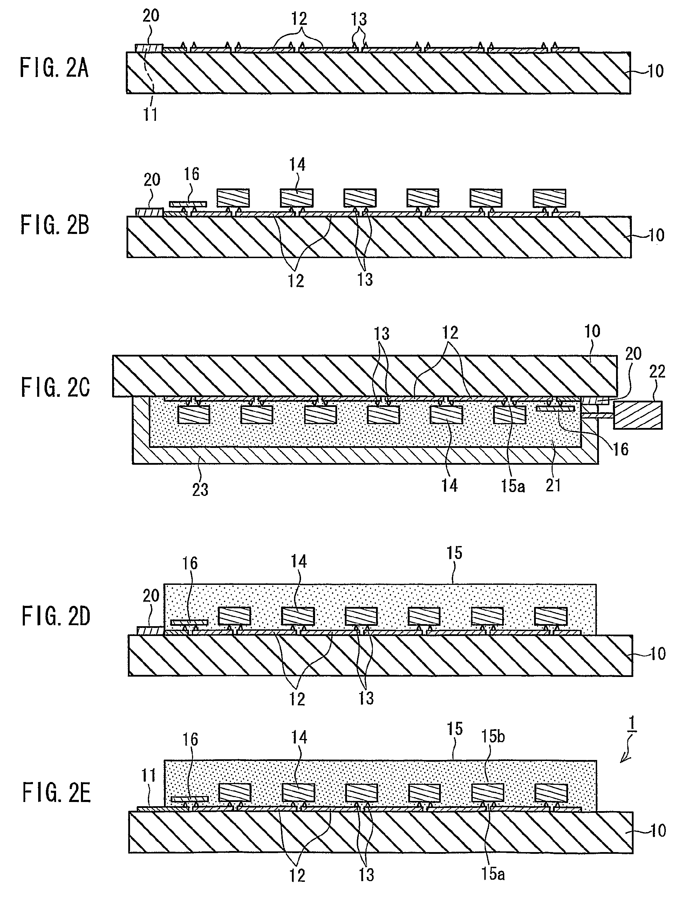

Next, a preferred method for manufacturing the semiconductor electroluminescent light source 1 will be described. FIGS. 2A to 2E referred to herein are cross-sectional views showing steps of the preferred method for manufacturing the semiconductor electroluminescent light source 1.

First, as shown in FIG. 2A, the peelable resin coating layer 20 is disposed on the substrate 10 on which the terminal 11 and the lands 12 are formed, so that the peelable resin coating layer 20 covers the terminal 11. With this, in the step of disposing the phosphor layer forming material 21 containing a phosphor and a silicone resin (see FIG. 2C), it is possible to prevent a phosphor layer forming material 21 from adhering to the terminal 11.

Next, as shown in FIG. 2B, the light-emitting elements 14 and the antistatic member 16 are mounted on the lands 12 via bumps 13.

Next, as shown in FIG. 2C, the phosphor layer forming material 21 is poured into a die 23, and the substrate 10 is stacked on the die 23 in a manner such that the light-emitting elements 14 and the antistatic member 16 are embedded in the phosphor layer forming material 21. Then, the pressure is reduced by a vacuum pump 22 so as to become less than 20 Pa in the die 23. Through this process, the light-emitting elements 14 are covered with the phosphor layer forming material 21, while the phosphor layer forming material 21 is filled in the first region 15a. Further, a heat treatment at 100°C to 180°C for one to five minutes is applied at the same time, whereby a primary curing operation is carried out with respect to the phosphor layer forming material 21.

Next, the die 23 is removed and a heat treatment at 100°C to 160°C for 30 to 180 minutes is applied, whereby a secondary curing operation is carried out with respect to the phosphor layer forming material 21. By so doing, the phosphor layer 15 is formed, as shown in FIG. 2D.

Then, the peelable resin coating layer 20 is peeled off, whereby the semiconductor electroluminescent light source 1 shown in FIG. 2E is obtained.

### Examples

Hereinafter, the present invention will be described by way of an illustrative example. It should be noted that the present invention is not limited to this example.

As an example of the present invention, a semiconductor electroluminescent light source as shown in FIGS. 1A and 1C was manufactured by the method shown in FIGS. 2A to 2E. It should be noted that the pressure was reduced so as to become 5 Pa in the die 23 in the step shown in FIG. 2C. As the substrate 10, a substrate made of Al₂O₃ (thickness T₁ (see FIG. 1C): 1mm) was used. As the light-emitting elements 14, a blue LED made of a GaN-based material (1 mm × 1 mm, thickness T₃ (see FIG. 1C): 300 µm) was used. As the light-transmitting base material for forming the phosphor layer 15, a silicone resin was used. It should be noted that the phosphor was contained at a content of 15 wt% with respect to an entire weight of the phosphor layer 15. Further, a distance T₂ from a principal surface of the substrate 10 to the light-emitting elements 14 (see FIG. 1C) was 30 µm, while a distance T₄ from upper surfaces of the light-emitting elements 14 to an upper face of the phosphor layer 15 (see FIG. 1C) was 1200 µm.

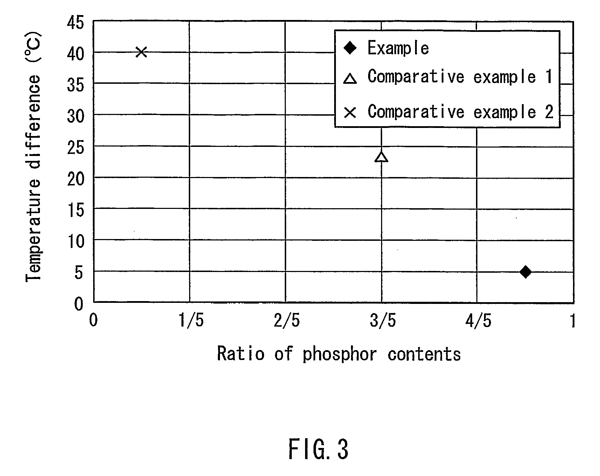

An electric current of 1 mA was fed to the semiconductor electroluminescent light source of the above-described example indoor at room temperature of 25°C, and was left to stand for one hour. After the electroluminescent light source assumed a static state, a temperature at a center part X of an upper surface of the phosphor layer 15 (see FIG. 1C), and a temperature at a center part Y of a lower surface of the substrate 10 (see FIG. 1C) were measured by an infrared radiation thermometer (Thermoviewer manufactured by Nippon Avionics Co., Ltd.), and a temperature difference (Y-X) was calculated. As Comparative Examples 1 and 2, luminescent light sources were prepared which were manufactured in the same manner as that of Example described above except that the pressure was reduced so as to become 0.1 Pa and 0.5 Pa, respectively, in the dies 23, and the temperature difference (Y-X) was calculated for each case in the same manner. The results are shown in FIG. 3. It should be noted that in the Example and Comparative Examples 1 and 2, ratios of contents by volume of phosphor (first region 15a / second region 15b) were 0.9, 0.6, and 0.1, respectively

As shown in FIG. 3, the temperature difference (Y-X) in the semiconductor electroluminescent light source of Example was smaller as compared with the electroluminescent light sources of Comparative Examples 1 and 2. Thus, a difference between heat dissipation properties of layers above and under the light-emitting elements 14 was decreased.

The invention may be embodied in other forms without departing from the scope of the invention as defined by the appended claims. The embodiments disclosed in this application are to be considered in all respects as illustrative and not limiting. The scope of the invention is indicated by the appended claims rather than by the foregoing description, and all changes which come within the meaning and range of equivalency of the claims are intended to be embraced therein.

### Industrial Applicability

The semiconductor electroluminescent and phosphor-converted light source of the present invention is useful in, for example, a lighting apparatus used in general lighting, presentation lighting (a sign light, etc.), automobile lighting (in particular, a headlight), or the like; and a display apparatus used in a large display for a street, a projector, or the like.

## Claims

1. A semiconductor electroluminescent light source (1) comprising:
a substrate (10);
a terminal (11) and a plurality of lands (12) formed on the substrate (10);
a plurality of light-emitting elements (14) mounted on the lands (12) via bumps (13); and
a phosphor layer (15) covering the plurality of light-emitting elements (14) and filling interstices (15a) between a principal surface of the substrate (10) and the light-emitting elements (14),
wherein
the phosphor layer (15) contains a phosphor and a light-transmitting base material,
a content by volume of the phosphor in a part of the phosphor layer (15) filling the interstices (15a) is not less than 80 % of the content by volume of the phosphor in the part (15b) of the phosphor layer (15) covering the plurality of light-emitting elements, and
an area of each land (12) is larger than an area of each light-emitting element (14) mounted on the lands (12).

2. The semiconductor electroluminescent light source (1) according to claim 1, wherein
the light-transmitting base material is a silicone resin.

3. A method for manufacturing a semiconductor electroluminescent light source (1), the method comprising the steps of:
disposing a peelable resin coating layer (20) on a substrate (10) on which a terminal (11) and a plurality of lands (12) are formed so that the peelable resin coating layer (20) covers the terminal (11);
mounting a plurality of light-emitting elements (14) on the lands (12) via bumps (13);
disposing a phosphor layer forming material (21) containing a phosphor and a light-transmitting base material under an ambient atmosphere pressure of less than 20 Pa so that the phosphor layer forming material (21) covers the plurality of light-emitting elements (14) and is filled in interstices (15a) between a principal surface of the substrate (10) and the plurality of light-emitting elements (14); and
peeling off the peelable resin coating layer (20).

4. The method for manufacturing a semiconductor electroluminescent light source (1) according to claim 3, wherein
a contact angle of the phosphor layer forming material (21) with respect to a surface of the lands (12) is smaller than a contact angle of the phosphor layer forming material (21) with respect to the principal surface of the substrate (10).

## Patentansprüche

1. Halbleiter-Elektrolumineszenz-Lichtquelle (1), umfassend:
ein Substrat (10);
einen Anschluss (11) und eine Mehrzahl von Lötaugen (12), die auf dem Substrat (10) gebildet sind;
eine Mehrzahl von Licht emittierenden Elementen (14), die auf den Lötaugen (12) mit Hilfe von Bumps (13) montiert sind; und
eine Phosphorschicht (15), die die Mehrzahl von Licht emittierenden Elementen (14) bedeckt und Zwischenräume (15a) zwischen einer Hauptoberfläche des Substrats (10) und den Licht emittierenden Elementen (14) füllt,
wobei
die Phosphorschicht (15) einen Phosphor und ein Licht übertragendes Grundmaterial enthält,
ein Volumengehalt des Phosphors in einem Teil der Phosphorschicht (15), der die Zwischenräume (15a) füllt, nicht weniger als 80 % des Volumengehalts des Phosphors in dem Teil (15b) der Phosphorschicht (15), die die Mehrzahl von Licht emittierenden Elementen bedeckt, beträgt, und
eine Fläche von jedem Lötauge (12) größer ist als eine Fläche von jedem Licht emittierenden Element (14), das auf den Lötaugen (12) montiert ist.

2. Halbleiter-Elektrolumineszenz-Lichtquelle (1) nach Anspruch 1, wobei das Licht übertragende Grundmaterial ein Silikonharz ist.

3. Verfahren zum Herstellen einer Halbleiter-Elektrolumineszenz-Lichtquelle (1), wobei das Verfahren die Schritte umfasst:
Anordnen einer abziehbaren Harzdeckschicht (20) auf einem Substrat (10), auf dem ein Anschluss (11) und eine Mehrzahl von Lötaugen (12) gebildet sind, sodass die abziehbare Harzdeckschicht (20) den Anschluss (11) bedeckt;
Montieren einer Mehrzahl von Licht emittierenden Elementen (14) auf den Lötaugen (12) mit Hilfe von Bumps (13);
Anordnen eines Phosphorschicht-Bildungsmaterials (21), das einen Phosphor und ein Licht übertragendes Grundmaterial enthält, unter einem Umgebungsluftdruck von weniger als 20 Pa, sodass das Phosphorschicht-Bildungsmaterial (21) die Mehrzahl von Licht emittierenden Elementen (14) bedeckt und in Zwischenräume (15a) zwischen einer Hauptoberfläche des Substrats (10) und der Mehrzahl von Licht emittierenden Elementen (14) gefüllt wird; und
Abziehen der abziehbaren Harzdeckschicht (20).

4. Verfahren zum Herstellen einer Halbleiter-Elektrolumineszenz-Lichtquelle (1) nach Anspruch 3, wobei
ein Kontaktwinkel des Phosphorschicht-Bildungsmaterials (21) in Bezug auf eine Oberfläche der Lötaugen (12) kleiner ist als ein Kontaktwinkel des Phosphorschicht-Bildungsmaterials (21) in Bezug auf die Hauptoberfläche des Substrats (10).

## Revendications

1. Source lumineuse électroluminescente à semi-conducteur (1) comprenant:
un substrat (10);
une borne (11) et une pluralité de pastilles (12) formées sur le substrat (10);
une pluralité d'éléments émetteurs de lumière (14) qui sont montés sur les pastilles (12) par l'intermédiaire de bosses (13); et
une couche de phosphore (15) qui recouvre la pluralité d'éléments émetteurs de lumière (14) et remplit des interstices (15a) entre une surface principale du substrat (10) et les éléments émetteurs de lumière (14),
dans laquelle
la couche de phosphore (15) contient un phosphore et une matière de base transmettant de la lumière,
une teneur en volume du phosphore dans une partie de la couche de phosphore (15) qui remplit les interstices (15a) n'est pas inférieure à 80 % de la teneur en volume du phosphore dans la partie (15b) de la couche de phosphore (15) qui recouvre la pluralité d'éléments émetteurs de lumière, et
une surface de chaque pastille (12) est supérieure à une surface de chaque élément émetteur de lumière (14) monté sur les pastilles (12).

2. Source lumineuse électroluminescente à semi-conducteur (1) selon la revendication 1, dans laquelle
la matière de base transmettant de la lumière est une résine de silicone.

3. Procédé de fabrication d'une source lumineuse électroluminescente à semi-conducteur (1), ledit procédé comprenant les étapes consistant à:
disposer une couche de recouvrement en résine (20) pelable sur un substrat (10) sur lequel sont formées une borne (11) et une pluralité de pastilles (12) de sorte que ladite couche de recouvrement en résine (20) pelable recouvre la borne (11);
monter une pluralité d'éléments émetteurs de lumière (14) sur les pastilles (12) par l'intermédiaire de bosses (13);
disposer une matière de formation de couche de phosphore (21) qui contient un phosphore et une matière de base transmettant de la lumière, à une pression d'air ambiant inférieure à 20 Pa de sorte que la matière de formation de couche de phosphore (21) recouvre ladite pluralité d'éléments émetteurs de lumière (14) et est introduite dans des interstices (15a) entre une surface principale du substrat (10) et la pluralité d'éléments émetteurs de lumière (14); et
peler la couche de recouvrement en résine (20) pelable.

4. Procédé de fabrication d'une source lumineuse électroluminescente à semi-conducteur (1), selon la revendication 3, dans lequel
un angle de contact de la matière de formation de couche de phosphore (21) par rapport à une surface des pastilles (12) est inférieur à un angle de contact de la matière de formation de couche de phosphore (21) par rapport à la surface principale du substrat (10).
